# EUROPÄISCHE PATENTSCHRIFT

(11) **EP 0 643 309 B1**
(45) Veröffentlichungstag und Bekanntmachung des Hinweises auf die Patenterteilung: **10.10.2001**
(21) Anmeldenummer: 94112812.6
(22) Anmeldetag: 17.08.1994
(51) Int. Cl.: G01R 31/06

(54) **Verfahren zur Erfassung von Erdfehlern auf den Leitern einer elektrischen Maschine**
Method for detecting ground faults on the conductors of an electric machine
Procédé pour détecter des défauts à la terre des conducteurs d'une machine électrique

(30) Priorität: 01.09.1993 DE 4329381
(43) Veröffentlichungstag der Anmeldung: 15.03.1995
(73) Patentinhaber: ABB Power Automation AG, 5401 Baden (CH)
(72) Erfinder: Pfiffner, Michael, CH-8906 Bonstetten (CH)
(74) Vertreter: ABB Patent Attorneys

(56) Entgegenhaltungen:
- EP-A- 0 131 718
- EP-A- 0 399 923
- DE-U- 8 909 829
- UNGRAD ET AL. 'SCHUTZTECHNIK IN ELEKTROENERGIESYSTEMEN' , SPRINGER-VERLAG , BERLIN * Seite 211, Absatz 2 - Seite 214, Absatz 1 *

## Beschreibung

### Technisches Gebiet

Die Erfindung bezieht sich auf das Gebiet der Schutztechnik.

Sie geht aus von einem Verfahren zur Erfassung von Erdfehlern auf den Leitern einer elektrischen Maschine nach dem Oberbegriff des ersten Anspruchs.

### Stand der Technik

Ein solches Verfahren wird z.B. in der Gerätebeschreibung "100% Stator- und Rotor-Erdschlussschutz für grosse Generatoren GIX 104" der ABB Relays AG, Baden beschrieben. Ein verwandtes Verfahren wird in der Gerätebeschreibung "100%-iger Generator-Statorerdschluss-Schutz GIX 103" der selben Firma beschrieben.

Erdfehler treten in einer elektrischen Maschine, insbesondere in Generatoren grösserer Leistung, hauptsächlich durch mechanische Beschädigung der Isolation zwischen den Leitern und den Eisenteilen auf. Aufgrund solcher Erdfehler fliesst ein Fehlerstrom, dessen Grösse je nach der Art des Fehlers verschiedene Werte annimmt. Nach dem Ohmschen Gesetz kann daraus bei bekannter Spannung ein Fehlerwiderstand ermittelt werden, dessen Grösse zur Beurteilung des Fehlers herangezogen werden kann. Im Normalfall weist der Fehlerwiderstand Werte im Bereich von MΩ auf, bei Fehlern kann er auf um Grössenordnungen kleinere Werte absinken.

Da der Sternpunkt in den zum Stern geschalteten Leitern z.B. des Stators definitionsgemäss spannungslos ist, kann ein Fehler in der Nähe des Sternpunkts nur erfasst werden, wenn die Leiter gegenüber dem Erdpotential verspannt werden. Dies geschieht bei beiden bekannten Schutzeinrichtungen und Verfahren mittels einer niederfrequenten Spannung, welche in die Leiter eingespeist wird.

Im Betrieb fliesst damit ein kleiner Strom durch die Erdkapazitäten der Leiter gegen Erde. Bei einem Erdfehler werden diese Kapazitäten kurzgeschlossen, und der Strom wird grösser als im erdschlussfreien Betrieb.

Beim GIX103 wird ein Injektionssignal verwendet, wie es im Buch "Schutztechnik in Elektroenergiesystemen", S. 211 ff., von H. Ungrad et al., Springer Verlag, beschrieben wird. Es handelt sich um ein Rechtecksignal, welches während 3.25 Perioden von einem positiven Wert auf einen negativen Wert umschaltet. Es beginnt mit einer positiven Viertelperiode und endet mit einer positiven Halbperiode. Dieses Signal wird über einen Injektionswandler in die Leiter eingespeist. Der magnetische Fluss im Injektionswandler ist proportional zum Integral des Injektionssignals Ui. Beim Signal nach dem Stand der Technik ergibt sich durch die Halbperiode am Ende des Injektionssignal ein Fluss, welcher am Ende der Sendeperiode nicht zu Null wird. Dadurch ist die Anfangsbedingung für die nächste Injektionsphase grösser Null und es treten überhöhte Einschwingvorgänge des Flusses auf, so dass im Injektionswandler eine Sättigung auftritt und der Injektionswandler überdimensioniert werden muss.

EP-A-0 399 923 offenbart ein Verfahren zur Bestimmung einer zeitvarianten Phasenverschiebung eines Messtransformators, welcher zur Bestimmung von Erdwiderständen und Streukapazitäten einer elektrischen Anlage dient. Dazu wird der Messtransformator mit einem Injektionssignal gespiesen, welches eine Sendeperiode und eine Pausenperiode aufweist. Anhand von Messwerten einer Spannungsamplitude während der Sende- bzw Pausenperiode wird die Phasenverschiebung des Messtransformators berechnet.

DE-U-89 09 829 zeigt ein Erdschluss-Anzeigegerät welches für beliebig hohe Betriebsspannungen ausgelegt ist. Dazu wird ein Koppeltransformator zur Einspeisung eines Rechtecksignals bei galvanischer Isolation gegenüber der hohen Spannung verwendet.

### Darstellung der Erfindung

Aufgabe der vorliegenden Erfindung ist es deshalb, ein Verfahren und eine Vorrichtung zur Erfassung von Erdfehlern auf den Leitern einer elektrischen Maschine anzugeben, bei welchem der Injektionswandler optimal ausgenützt wird.

Diese Aufgabe wird bei einem Verfahren der eingangs genannten Art durch die Merkmale des ersten Anspruchs gelöst.

Kern der Erfindung ist es also, dass das Injektionssignal ein Rechtecksignal darstellt, welches zwischen einem positiven und einem negativen Maximum periodisch umgeschaltet wird und am Anfang und am Ende der Sendeperiode eine Viertelperiode entweder des positiven oder des negativen Maximums aufweist.

Aufgrund dieser beiden Viertelperioden am Anfang und am Ende der Sendeperiode befindet sich das Integral des Injektionssignals, welches ja proportional zum Fluss ist, sofort im eingeschwungenen Zustand, d.h. es bildet ein Dreiecksignal, welches bei Null beginnt und wieder aufhört. Der magnetische Fluss ist damit ebenfalls schon am Anfang der Sendeperiode eingeschwungen. Dieser Umstand fällt besonders bei der Dimensionierung des Injektionswandler positiv ins Gewicht, denn es kann die max. Spannungszeitfläche übertragen werden ohne dass eine Sättigung auftritt. Die Ausnutzung des Wandlers ist also optimal, und der Wandler muss nicht überdimensioniert werden.

Es ist nun möglich, dass das Injektionssignal entweder mit zwei Viertelperioden gleichen Vorzeichens oder unterschiedlichen Vorzeichens beginnen bzw. enden zu lassen. Diese beiden Varianten stellen zwei Ausführungsformen dar.

Beide Ausführungsformen zeichnen sich dadurch aus, dass Injektionssignal aus einem Produkt zweier Rechtecksignale gebildet wird. Das erste Rechtecksignal schaltet symmetrisch zwischen einem positiven und einem negativen Wert mit der Frequenz f1 des Injektionssignals um. Das zweite Rechtecksignal weist z.B. eine Frequenz f2=f1/8 bzw. f2=f1/7 auf und schaltet zwischen einem positiven Wert und Null um. Zudem weist es gegenüber dem ersten Rechtecksignal eine Phasenverschiebung von 1/(4*f1) auf. Multipliziert man die beiden Rechtecksignale, so erhält man des gewünschte Injektionssignal.

Das erfindungsgemässe Verfahren wird vorteilhafterweise bei Drehstrommaschinen, insbesondere bei Generatoren hoher Leistung, eingesetzt. Es kann aber auch bei hochohmig geerdeten Transformatoren parallel zu einem Generator verwendet werden.

Weitere Ausführungsbeispiele ergeben sich aus den Unteransprüchen.

Der Vorteil des erfindungsgemässen Aufbaus besteht insbesondere darin, dass der Injektionswandler zur Übertragung des Injektionssignals nicht unnötig überdimensioniert, sondern optimal ausgenützt werden kann.

### Kurze Beschreibung der Zeichnungen

Nachfolgend wird die Erfindung anhand von Ausführungsbeispielen im Zusammenhang mit den Zeichnungen näher erläutert.

Es zeigen:
- **Fig. 1a,b**: Die prinzipielle Schaltungsanordnung für eine Erdfehler-Erfassung am Stator (a) bzw. Rotor (b) einer Drehstrommaschine;
- **Fig. 2**: Den Verlauf und die Erzeugung der Injektionsspannung bzw. dessen Integral nach einem ersten Ausführungsbeispiel;
- **Fig. 3**: Den Verlauf und die Erzeugung der Injektionsspannung bzw. dessen Integral nach einem zweiten Ausführungsbeispiel.

Die in den Zeichnungen verwendeten Bezugszeichen und deren Bedeutung sind in der Bezeichnungsliste zusammengefasst aufgelistet. Grundsätzlich sind in den Figuren gleiche Teile mit gleichen Bezugszeichen versehen.

### Wege zur Ausführung der Erfindung

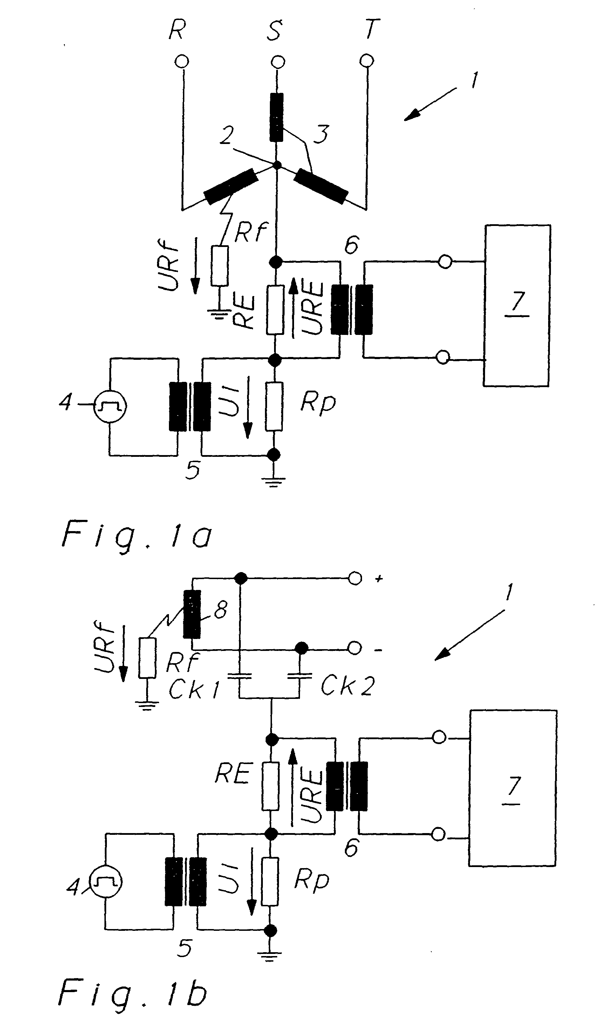

Figur 1a zeigt die prinzipielle Schaltungsanordnung zur Erfassung von Erdfehlern auf den Statorwicklungen (3) einer elektrischen Maschine, insbesondere einer Drehstrommaschine. Damit Erdfehler auf der gesamten Wicklung (3) erfasst werden können, wird der Sternpunkt (2) der Wicklung (3) mittels eines Injektionssignals (Ui) verspannt. Dieses Injektionssignal (Ui) wird in einer Injektionssignalquelle (4) generiert und über einen Injektionswandler (5) und einen Erdungswiderstand (RE) in den Sternpunkt (2) eingespeist. Zur Erfassung der Erdfehler wird über dem Erdungswiderstand (RE) die Spannung (URE) gemessen und über einen Messwandler (6) einer Auswerteeinheit (7) zugeführt. In der Auswerteeinheit (7) wird anhand der injizierten (Ui) und der gemessenen Spannung (URE) der Fehlerwiderstand (Rf) berechnet.

Beim Rotor sind die Verhältnisse nicht wesentlich anders. Es kommen nur unter Umständen zwei Koppelkondensatoren (Ck1, Ck2) hinzu. **Figur 1b** zeigt das entsprechende Schaltbild.

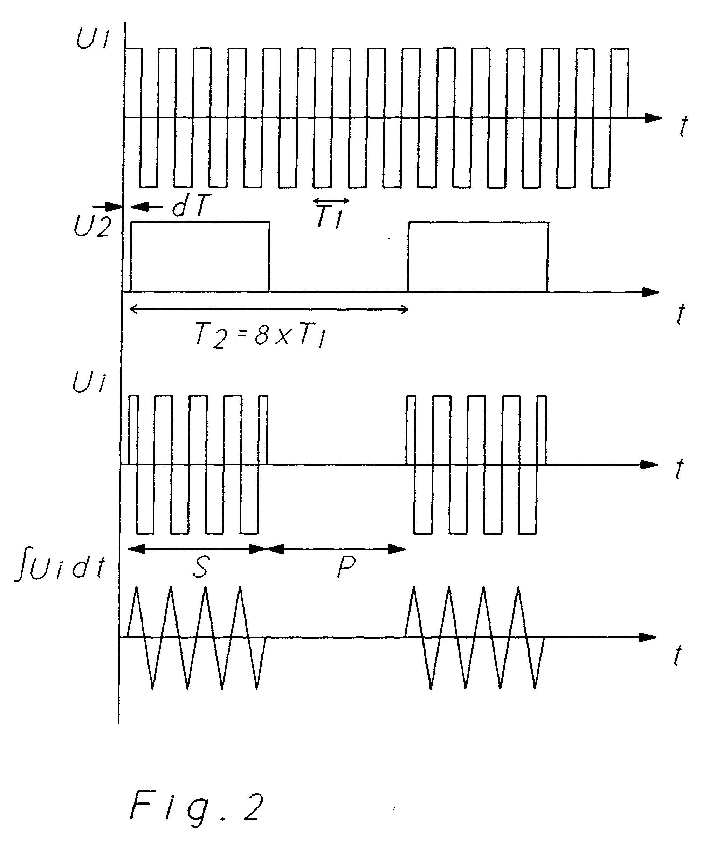

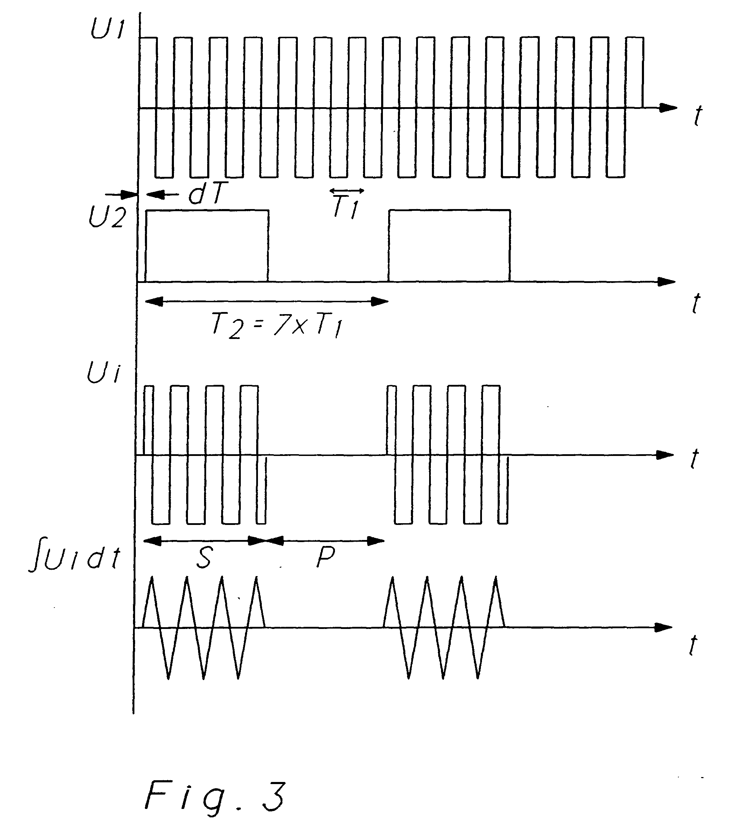

Wesentlich für die Erfindung ist nun die Form und Art der Erzeugung des Injektionssignals (Ui) **(Figur 2 bzw. 3**). Aus dem Stand der Technik ist bekannt, dass das Injektionssignal (Ui) einerseits eine Sendeperiode (S) und andererseits eine Pausenperiode (P) aufweisen soll. Dadurch wird es möglich, in der Pause (P) das System nach anderen Signalen der Injektionsfrequenz (f1) zu untersuchen. Dies ermöglicht eine Unterscheidung von transienten oder anderen störenden Signalen von den Nutzsignalen und hilft damit, Fehlauslösungen des Schutzsystems zu vermeiden.

Während der Sendeperiode (S) weist das Injektionssignal (Ui) nun vorteilhafterweise sowohl am Anfang wie am Ende eine Viertelperiode auf. Dadurch ist das Integral, d.h. der Fluss von Beginn weg im eingeschwungenen Zustand und endet auch mit Null. Deshalb kann im Injektionswandler (5) keine Sättigung auftreten und der Wandler (5) muss auch nicht für grössere Flüsse dimensioniert werden. Er kann mit anderen Worten optimal ausgenützt werden.

Eine erste Ausführungsform (Figur 2) zeichnet sich dadurch aus, dass das Injektionssignal (Ui) sowohl am Anfang wie am Ende eine Viertelperiode mit gleichem Vorzeichen aufweist.

Bei einer zweiten Ausführungsform (Figur 3) sind die Vorzeichen entgegengesetzt.

Beiden Ausführungsbeispielen ist gemeinsam, dass die Injektionssignale (Ui) am einfachsten mittels Multiplikation zweier Rechtecksignale gebildet werden. In beiden Fällen wird von einer symmetrischen Rechtecksschwingung (U1) der Frequenz f1 des Injektionssignals (Ui) ausgegangen. Diese wird nun mit einem zweiten Rechtecksignal (U2) mit einer Frequenz f2 multipliziert, wobei die Frequenz f2 einen Bruchteil (f1/n) der Frequenz f1 beträgt, n gerade oder ungerade. Besonders bevorzugt werden die Frequenz f2=f1/8 bzw. f2=f1/7. Dieses Rechtecksignal (U2) schaltet dabei nur von Null auf einen positiven Wert und weist zudem gegenüber dem Injektionssignal (Ui) eine Phasenverschiebung (dT) von 1/(4*f1) auf.

Durch die Multiplikation der beiden Rechtecksignale (U1, U2) erhält man ein Injektionssignal (Ui), welches den gewünschten Verlauf während der Sendeperiode (S) aufweist und zudem korrekt in Sendeperiode (S) und Pausenperiode (P) aufgeteilt ist.

Die oben beschriebenen Varianten des Injektionssignals (Ui) sind selbstverständliche nicht beschränkt auf Anwendungen in Erdfehlererfassungsgeräten, sondern werden mit Vorteil überall dort angewendet, wo Rechtecksignale über einen Wandler (5) übertragen werden sollen.

Insgesamt steht mit dem erfindungsgemässen Signalformen ein Verfahren zur Erfassung von Erdfehlern auf den Leitern einer elektrischen Maschine, bei welchem der Injektionswandler (5) optimal ausgenützt wird.

### Bezeichnungsliste

- 1: Stator
- 2: Sternpunkt
- 3: Statorwicklungen
- 4: Injektionssignalquelle
- 5: Injektionswandler
- 6: Messwandler
- 7: Auswerteeinheit
- 8: Rotorwicklung

- R, S, T: Statorklemmen
- +, -: Rotorklemmen
- Rf: Fehlerwiderstand
- RE: Erdungswiderstand
- Rp: Parallelwiderstand
- CE: Erdkapazität
- Ck1, Ck2: Koppelkapazitäten
- Ui: Injektionsspannung
- U1, U2: Hilfssignale
- URE: Messspannung
- f1: Frequenz des Injektionssignals
- f2: Frequenz von U2
- T1: Periodendauer des Injektionssignals
- T2: Periodendauer des Hilfssignals U2
- dT: Phasenverschiebung

## Patentansprüche

1. Verfahren zur Erfassung von Erdfehlern auf den Leitern einer elektrischen Maschine, bei welchem Verfahren
a) die Leiter mittels eines niederfrequenten Injektionsspannungssignals (Uᵢ) der Frequenz f1 gegenüber dem Erdpotential verspannt werden, wobei das Injektionssignal (Ui) eine Sendeperiode (S) und eine Pausenperiode (P) aufweist,
**dadurch gekennzeichnet, dass**
b) das Injektionssignal (Ui) in der Sendeperiode (S) ein Rechtecksignal umfasst, welches zwischen einem positiven und einem negativen Maximum periodisch umgeschaltet wird und am Anfang und am Ende der Sendeperiode (S) eine Viertelperiode entweder des positiven oder des negativen Maximums aufweist.

2. Verfahren nach Anspruch 1, **dadurch gekennzeichnet, dass** das Injektionssignal (Ui) sowohl am Anfang wie am Ende der Sendeperiode (S) eine positive Viertelperiode aufweist.

3. Verfahren nach Anspruch 1, **dadurch gekennzeichnet, dass** das Injektionssignal (Ui) am Anfang der Sendeperiode (S) eine positive und am Ende eine negative Viertelperiode aufweist.

4. Verfahren nach Anspruch 2 oder 3 **dadurch gekennzeichnet, dass** das Injektionssignal (Ui) aus dem Produkt eines ersten Rechtecksignals (U1), welches die Frequenz f1 aufweist und symmetrisch um Null auf einen ersten, positiven bzw. negativen Wert umgeschaltet wird, und eines zweiten Rechtecksignals (U2), welches die Frequenz f2=f1/n, n gerade oder ungerade, aufweist, zwischen einem zweiten, positiven Wert und Null umgeschaltet wird und gegenüber dem ersten (U1) eine Phasenverschiebung (dT) von 1/(4*f1) aufweist.

5. Verfahren nach Anspruch 4, **dadurch gekennzeichnet, dass** die Frequenz (f2) des zweiten Rechtecksignals (U2) f1/8 beträgt, n also gleich 8 ist.

6. Verfahren nach Anspruch 4, **dadurch gekennzeichnet, dass** die Frequenz (f2) des zweiten Rechtecksignals (U2) f1/7 beträgt, n also gleich 7 ist.

7. Verfahren nach einem der vorangehenden Ansprüche, **dadurch gekennzeichnet, dass** die Frequenz (f1) des Injektionssignals (Ui) ein Viertel der Nennfrequenz beträgt.

8. Verfahren nach einem der vorangehenden Ansprüche, **dadurch gekennzeichnet, dass** es sich bei der elektrischen Maschine um eine Drehstrommaschine, insbesondere um einen Generator handelt.

## Claims

1. Method for detecting earth faults on the conductors of an electrical machine, in which method
a) the conductors are biased with respect to the earth potential by means of a low-frequency injection voltage signal (Uᵢ) of frequency f1, the injection signal (Ui) having a transmission period (S) and a pause period (P), charaterized in that
b) the injection signal (Ui) in the transmission period (S) comprises a square-wave signal which is switched over periodically between a positive and a negative maximum and has at the start and at the end of the transmission period (S) a quarter-period either of the positive or of the negative maximum.

2. Method according to Claim 1, **characterized in that** the injection signal (Ui) has a positive quarter-period both at the start and at the end of the transmission period (S).

3. Method according to Claim 1, **characterized in that** the injection signal (Ui) has a positive quarter-period at the start of the transmission period (S) and a negative quarter-period at the end.

4. Method according to Claim 2 or 3, **characterized in that** the injection signal (Ui) composed of the product of a first square-wave signal (U1), which is of frequency f1 and is switched over symmetrically about zero to a first, positive or negative value, and a second square-wave signal (U2) which is of frequency f2=f1/n, n being even or odd, is switched over between a second, positive value and zero and has a phase shift (dT) of 1/(4*f1) with respect to the first (U1).

5. Method according to Claim 4, **characterized in that** the frequency (f2) of the second square-wave signal (U2) is f1/8, n thus being equal to 8.

6. Method according to Claim 4, **characterized in that** the frequency (f2) of the second square-wave signal (U2) is f1/7, n thus being equal to 7.

7. Method according to one of the preceding claims, **characterized in that** the frequency (f1) of the injection signal (Uᵢ) is a quarter of the nominal frequency.

8. Method according to one of the preceding claims, **characterized in that** the electrical machine is a three-phase machine, in particular a generator.

## Revendications

1. Procédé de détection de défauts d'isolation par rapport à la terre sur les conducteurs d'une machine électrique, dans lequel :
a) les conducteurs sont placés sous tension par rapport au potentiel de terre au moyen d'un signal de tension d'injection (Uᵢ) à basse fréquence, de fréquence f1, le signal d'injection (Ui) présentant une période d'émission (S) et une période de pose (P),
**caractérisé en ce que**
b) dans la période d'émission (S), le signal d'injection (Ui) comporte un signal rectangulaire qui est basculé périodiquement entre une valeur maximale positive et une valeur maximale négative, et au début et à la fin de la période d'émission (S) , il présente un quart de période soit au maximum positif, soit au maximum négatif.

2. Procédé selon la revendication 1, **caractérisé en ce que** le signal d'injection (Ui) présente un quart de période positif tant au début qu'à la fin de la période d'émission (S).

3. Procédé selon la revendication 1, **caractérisé en ce que** le signal d'injection (Ui) présente un quart de période positif au début de la période d'émission (S) et un quart de période négatif à la fin de celle-ci.

4. Procédé selon la revendication 2 ou 3, **caractérisé en ce que** le signal d'injection (Ui) est constitué du produit d'un premier signal rectangulaire (U1) qui présente la fréquence f1 et qui bascule symétriquement autour de zéro entre une première valeur positive et une première valeur négative, et d'un deuxième signal rectangulaire (U2) qui présente la fréquence f2=f1/n, n étant pair ou impair, qui bascule entre une deuxième valeur positive et zéro et présente par rapport au premier (U1) un déphasage (dT) de 1/(4*f1).

5. Procédé selon la revendication 4, **caractérisé en ce que** la fréquence (f2) du deuxième signal rectangulaire (U2) vaut f1/8, n étant alors égal à 8.

6. Procédé selon la revendication 4, **caractérisé en ce que** la fréquence (f2) du deuxième signal rectangulaire (U2) vaut f1/7, n étant alors égal à 7.

7. Procédé selon l'une des revendications précédentes, **caractérisé en ce que** la fréquence (f1) du signal d'injection (Ui) vaut un quart de la fréquence nominale.

8. Procédé selon l'une des revendications précédentes, **caractérisé en ce que** la machine électrique est une machine à courant tournant, en particulier un générateur.
